# EUROPEAN PATENT SPECIFICATION

(11) **EP 3 925 806 B1**
(45) Date of publication and mention of the grant of the patent: **06.12.2023**
(21) Application number: 21180432.3
(22) Date of filing: 18.06.2021
(51) Int. Cl.: B60H 1/00, F25B 25/02, F25B 40/02, F25B 39/04, B60H 1/32, F25B 49/02

(54) **INTEGRATED COOLING SYSTEM AND METHOD FOR TRANSPORTATION REFRIGERATION UNIT**
INTEGRIERTES KÜHLSYSTEM UND VERFAHREN FÜR TRANSPORTKÜHLEINHEIT
SYSTÈME DE REFROIDISSEMENT INTÉGRÉ ET PROCÉDÉ POUR UNITÉ DE RÉFRIGÉRATION DE TRANSPORT

(30) Priority: 19.06.2020 US 202062705274 P
(43) Date of publication of application: 22.12.2021
(73) Proprietor: Carrier Corporation, Palm Beach Gardens, FL 33418 (US)
(72) Inventor: SENF, Jr., Raymond L., Syracuse, 13221 (US)
(74) Representative: Dehns

(56) References cited:
- WO-A1-2018/226649
- CN-U- 203 797 827
- US-A- 5 174 123

## Description

### BACKGROUND

The invention relates generally to transportation refrigeration units, and more specifically to a system and method for cooling a heat source in a transportation refrigeration unit.

Traditional refrigeration cargo trucks or refrigerated tractor trailers, such as those used to transport cargo via sea, rail or road, typically include a cargo compartment modified to include a refrigeration system located at one end of the truck, trailer, or cargo container. Refrigerator systems typically include a compressor, a condenser, an expansion valve, and an evaporator serially connected by refrigerant lines in a closed refrigerant circuit. In some cases a power unit, such as a combustion engine, provides power or drives the compressor of the refrigeration unit and may be diesel powered, natural gas powered, or another type of engine. In many tractor trailer transportation refrigeration systems, the compressor is driven by the engine shaft either through a belt drive or by a mechanical shaft-to-shaft link. In other systems, the engine of the refrigeration unit drives a generator that generates electrical power, which in turn, drives the compressor.

Trucks, trailers or engineless transportation refrigeration units (TRU) that use electric drive systems, including hybrid systems that may combine an internal combustion engine and an electric motor powered by an energy storage device (e.g., battery), may have one or more power electronics packages (PEP) on board. Generally, PEPs include systems and components for controlling and converting electrical power.

As power demands on the electrical systems in alternative fuel vehicles and TRUs increase, there is an ever increasing need to maximize efficiency and reliability of such systems. Additionally, there is a constant desire to reduce cost and space required by the components within the electrical system in order to minimize the overall cost and weight of vehicles and TRUs.

PEPs generate heat during operation which must be managed to ensure overall safe and reliable operation. A typical PEP is equipped with a heat sink (e.g., extended fin surfaces) for cooling, which adds weight and dimension to the PEP where space is generally limited. In addition, cooling is generally aided by forced air convection over the fins. However, forced air circulation over the PEP increases the risk that condensation will accumulate inside or outside the power electronics enclosure which can damage the PEP systems and components. What is needed then, is an improved system and method for managing heat produced by PEPs by eliminating extended fins and large heat sinks, and eliminating the need for unreliable dedicated forced air circulation.

WO 2018/226649 A1 discloses a transport refrigeration system including a transport refrigeration unit, an energy storage device, a supply refrigerant tube, a return refrigerant tube and at least one electrical pathway. CN 203 797 827 discloses a temperature control system which comprises a first heat exchanger, a second heat exchanger, an electronic element, a radiating device and a refrigerant cooling device. US 5 174 123 A discloses methods and apparatus which improve stationary refrigeration systems which utilize an economizer cycle, and the disclosure makes it possible to use a flash tank in a transport refrigeration system which has an economizer cycle, such as a screw compressor economizer cycle, by eliminating the need for a float valve.

### BRIEF DESCRIPTION OF THE INVENTION

As refrigeration cargo trucks, trailers and containers are increasingly powered, in whole or in part, by power electronics systems and components, a need exists to regulate the temperature of such systems to ensure safe and reliable operation. A power electronics package (PEP) may include direct current (DC) power supplies, direct current-to-alternating current (DC/AC) inverters (or power inverters) to convert DC power to AC power, which is generally required by a motor. Some vehicles, particularly fuel cell vehicles, may also use two separate voltage sources, such as a battery and a fuel cell, to power the electric motors that drive the wheels, and as such, batteries and/or fuel cells may also be included in a PEP. Other devices may also be included, such as power converters (e.g., direct current-to-direct current (DC/DC) which typically manage and transfer the power from the voltage sources.

The PEP generates heat as it supplies power to the truck and/or container. This heat must be dissipated to avoid overheating and damaging PEP systems and components. As described below, a transportation refrigeration system may be configured to allow the PEP to reject generated heat to a working fluid (e.g., refrigerant). In some embodiments, the PEP may be configured to operably couple to a section of the refrigeration flow circuit. For example, in one non-limiting embodiment, the PEP may be positioned adjacent to the subcooler 80 in the subcooler refrigerant flow circuit. The PEP, which may be stored in a container (e.g., a heat transfer apparatus 120) may have a channel through which the working fluid may flow. Heat from the PEP may be rejected to the working fluid as it passes through (or in some cases, over) the PEP.

According to the present invention, there is provided a transportation refrigeration system as recited in claim 1.

Optionally, the transportation refrigeration system further includes: a compressor including a suction port and a discharge port, the compressor configured to circulate a working fluid through a flow circuit wherein, the heat rejection heat exchanger is operably coupled to a compressor discharge port; and a heat absorption heat exchanger is operably coupled to a compressor suction port.

Optionally, the heat transfer apparatus includes the heat sink, wherein the heat sink includes at least two plates operably coupled together in parallel forming a flow channel between adjacent plates, and is disposed between the first portion and the second portion.

Optionally, the heat source includes a power electronics device.

Optionally, the power electronics device controls the flow of electricity between one or more of a battery, a motor, a generator, a refrigeration transportation system, and a vehicle powertrain.

Optionally, the power electronics device includes at least one of a power semiconductor device, a converter, an inverter, a battery, and a fuel cell.

According to the present invention, there is provided a method of operating a transportation refrigeration system as recited in claim 6.

Optionally, the working fluid is a high pressure, subcooled refrigerant.

Optionally, the heat source includes a power electronics device.

Optionally, the power electronics device controls the flow of electricity between one or more of a battery, a motor, a generator, a refrigeration transportation system, and a vehicle powertrain.

Optionally, the power electronics device includes at least one of a power semiconductor device, a converter, an inverter, a battery, and a fuel cell.
The method comprises providing and/or using a transportation refrigeration system as described herein with reference to claim 1

### BRIEF DESCRIPTION OF THE DRAWINGS

The accompanying drawings are provided by way of example and form a part of the specification. Throughout the drawings, like reference numbers identify like elements.
FIG. 1 illustrates a transportation refrigeration system having an engineless transportation refrigeration unit (TRU).
FIG. 2 illustrates a schematic of the engineless transportation refrigeration unit.
FIG. 3 illustrates a schematic of a portion of the engineless transportation refrigeration unit.
FIG. 4 is a flow diagram illustrating a method of operating a transportation refrigeration unit.

These and other advantages and features will become more apparent from the following description taken in conjunction with the drawings.

### DETAILED DESCRIPTION OF THE INVENTION

A detailed description of one or more embodiments of the disclosed system and method are presented here by way of exemplification and not limitation with reference to the Figures.

As discussed below, an engineless transportation refrigeration unit (TRU) 26 may be equipped with one or more power electric devices for controlling and converting electrical power. Generally, power electronics is technology associated with the efficient conversion, control and conditioning of electric power by static means from its available input form into the desired electrical output form. Some electronic systems are concerned with transmission and processing of signals and data and do not process substantial amounts of energy. However, power conversion using power electronics is performed with semiconductor switching devices such as diodes, thyristors and transistors, and substantial amounts of electrical energy are processed. The heat generated by such power electronics during operation should be removed from the system to avoid damaging these devices and to ensure continued safe operation.

In general, a power electronics package (PEP) includes power electronics devices that control the flow of electricity between one or more of a battery, a motor, a generator, a refrigeration transportation system 100, and a vehicle (e.g., truck) powertrain. Batteries, fuel cells, converters, inverters, and power semiconductor devices that may include power diodes, thyristors, power transistors (e.g., MOSFET and IGBT) may be included in a PEP. For example, a frequency converter may be included to regulate the speed of compressor 50. An inverter assembly, for example, may be included to convert DC power into AC power, before the power is sent to an electric motor (e.g., motor 52).

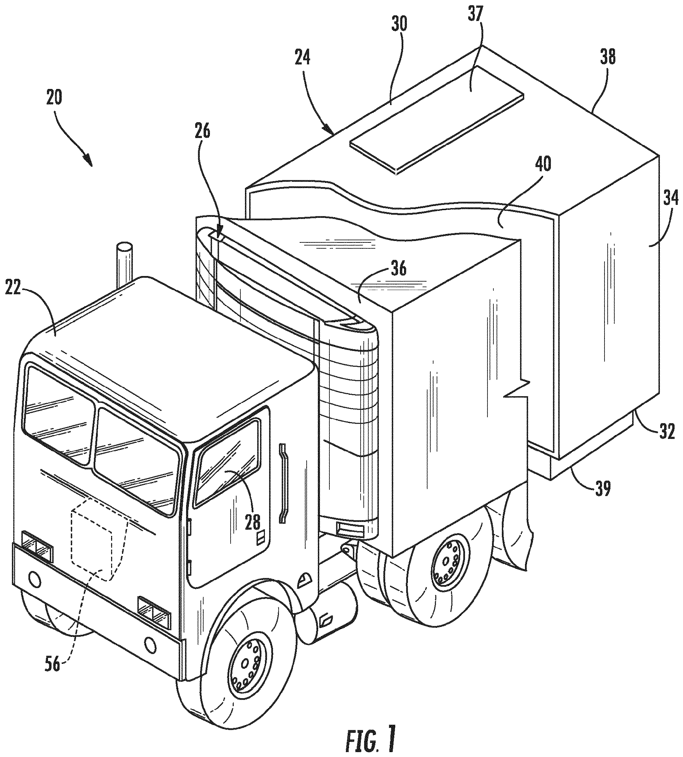

Referring to FIG. 1, a transportation refrigeration system 20 of the present disclosure is illustrated. In the illustrated embodiment, the transportation refrigeration system 20 may include a tractor or vehicle 22, a container 24, and an engineless transportation refrigeration unit (TRU) 26. The container 24 may be pulled by a vehicle 22. It is understood that embodiments described herein may be applied to shipping containers that are shipped by rail, sea, air, or any other suitable container, thus the vehicle may be a truck, train, boat, airplane, helicopter, etc.

The vehicle 22 may include an operator's compartment or cab 28 and a combustion engine 56 which is part of the powertrain or drive system of the vehicle 22. The container 24 may be coupled to the vehicle 22 and is thus pulled or propelled to desired destinations. The trailer may include a top wall 30, a bottom wall 32 opposed to and spaced from the top wall 30, two side walls 34 spaced from and opposed to one another, and opposing front and rear walls 36, 38 with the front wall 36 being closest to the vehicle 22. The container 24 may further include doors (not shown) (e.g., at the rear wall 38). In addition, container 24 may further include a renewable power source 37 (e.g., solar panel) configured to, among other things, recharge batteries of an energy storage device 39. The walls 30, 32, 34, 36, 38 together define the boundaries of a cargo compartment 40.

Typically, transportation refrigeration systems 20 are used to transport and distribute cargo, such as, for example perishable goods and environmentally sensitive goods (herein referred to as perishable goods). The perishable goods may include but are not limited to fruits, vegetables, grains, beans, nuts, eggs, dairy, seed, flowers, meat, poultry, fish, ice, blood, pharmaceuticals, or any other suitable cargo requiring cold chain transport. In the illustrated embodiment, the TRU 26 is associated with a container 24 to provide desired environmental parameters, such as, for example, temperature, pressure, humidity, carbon dioxide, ethylene, ozone, light exposure, vibration exposure, and other conditions to the cargo compartment 40. In further embodiments, the TRU 26 is a refrigeration system capable of providing a desired temperature and humidity range.

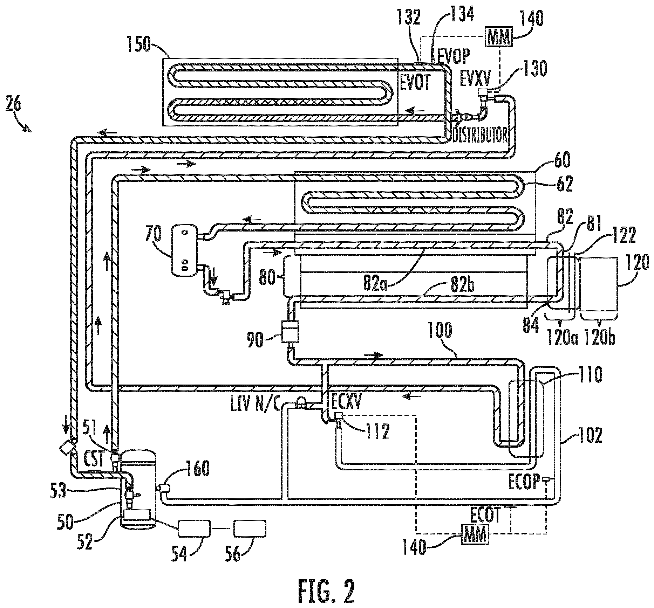

Referring to FIGS. 1 and 2, the TRU 26 is generally integrated into container 24 and may be mounted to the front wall 36. The cargo is maintained at a desired temperature by cooling of the compartment 40 via the TRU 26 that circulates airflow into and through the cargo compartment 40 of container 24. It is further contemplated and understood that TRU 26 may be applied to any transport compartment (e.g., shipping or transport containers) and not necessarily those used in tractor trailer systems. Furthermore, the transport container 24 may be a part of vehicle 22 or constructed to be removed from a framework and wheels (not shown) of container 24 for alternative shipping means (e.g., marine, railroad, flight, and others).

FIG. 2 is a schematic representation of a TRU 26 in an exemplary embodiment. The TRU 26 may circulate a working fluid in a closed loop, to control the temperature in a space, such as cargo compartment 40 of container 24. The working fluid may be circulated to absorb and remove heat from the space and may subsequently reject the heat elsewhere. The working fluid may be a refrigerant or a mixture of refrigerant and a non-refrigerant or a blend thereof in gas, liquid or multiple phases. In some embodiments, the working fluid may be a natural refrigerant, hydro-fluorocarbon (HFC), HFC R-134a, R-404a, among others. The natural refrigerant may be CO₂, propane, ammonia, or other natural refrigerant that may include a global-warming potential (GWP) of about 1. It is understood that the transportation refrigeration system of FIG. 1 and the TRU 26, each as described below in accordance with embodiments of this disclosure, generally describes a single stage vapor compression system.

Compressor 50 may be a single compressor, a two-stage compressor, a scroll-type compressor or other compressors adapted to compress HFCs or natural refrigerants. Other refrigerant systems may be a two-stage vapor compression system. Compressor 50 includes a motor 52 which may be an integrated electric drive motor driven by a synchronous generator 54. Generator 54 may be driven by a diesel engine 56 of a vehicle that tows TRU 26. Alternatively, generator 54 may be driven by a stand-alone engine 56. In an exemplary embodiment, engine 56 is a diesel engine.

High temperature, high pressure vapor refrigerant exits at discharge port 51 of compressor 50 then flows generally in the direction of the arrows depicted in FIG. 2, to a heat rejection heat exchanger 60 (e.g., condenser or gas cooler). The heat rejection heat exchanger 60 and the subcooler 80 discussed below, each include a plurality of condenser coil fins and tubes 62, 82, which receive air, typically blown by a heat rejection heat exchanger fan (not shown). By removing latent heat through this step, the refrigerant condenses to a high pressure/high temperature liquid and flows to the receiver 70 that provides storage for excess liquid refrigerant during low temperature operation.

From the receiver 70, the high pressure refrigerant flows to a subcooler 80, which increases the refrigerant subcooling. Subcooler 80 may be positioned adjacent to the heat rejection heat exchanger 60 and cooled by air flow from a heat rejection heat exchanger fan (not shown). The subcooler 80 may be a single-pass type subcooler, or as illustrated, a multi-pass type subcooler 80 such that the coil fins and tubes 82 are configured to make multiple passes through subcooler 80. For example, subcooler 80 may have a plurality of flow paths, such as a first flow path 82a and at least a second flow path 82b, wherein first flow path 82a fluidly connects the heat rejection heat exchanger 60 with subcooler 80, and at least a second flow path 82b, that fluidly connects the subcooler 80 with an economizer heat exchanger 110.

A heat transfer apparatus 120 may be disposed between the plurality of flow paths (e.g., 82a, 82b) to provide a heat exchange between the working fluid and a heat source associated with the heat transfer apparatus 120. In one non-limiting embodiment, the working fluid enters the heat transfer apparatus 120 through inlet port 81 as a high pressure subcooled refrigerant. In some embodiments, the heat source may include one or more power electronic devices as discussed above.

The heat transfer apparatus 120 may be a single apparatus, or may include an assembly having a first portion 120a, a second portion 120b and a heat sink 122. Each of the first portion 120a, the second portion 120b and the heat sink 122 may be configured to operably couple together. In some embodiments, the heat sink 122 may be integral to the first portion 120a and/or the second portion 120b. Any one of the first portion 120a, the second portion 120b and/or the heat sink 122 may be made of any suitable material, including metal and/or plastics.

In some embodiments, the first portion 120a may be configured to permit a plurality of flow paths (e.g., 82a, 82b) to attached to or pass over the exterior surface of heat transfer apparatus 120. In an alternative embodiment, the first portion 120a and/or the second portion 120b may be configured to permit a plurality of flow paths (e.g., 82a, 82b) to pass through the first portion 120a and/or second portion 120b via one or more inlets or channels such that the plurality of flow paths (e.g., 82a, 82b) may enter the heat transfer apparatus 120 to permit the plurality of flow paths 82a, 82b to be adjacent to heat sink 122. This flow arrangement allows for a heat exchange to occur between the heat transfer apparatus 120 and the working fluid, and without the necessity of a separate pump to move the working fluid through or around the heat transfer apparatus 120.

In some embodiments, the second portion 120b may operably couple to the heat source. In an alternate embodiment, the second portion 120b may include an enclosure for housing the heat source. In some embodiments, the second portion 120b may include a lid that is openable to allow easy access to the heat source, seals to provide a leak-free and dust free environment, and insulation to provide protection from extreme external temperatures, such extreme heat or cold when the TRU 26 is located in an extreme weather environment.

The shape and dimension of the heat sink 122 may vary depending on a variety of factors, including the dimensions of the heat transfer apparatus 120, and the amount of heat to be dissipated from the heat source. The heat sink 122 may include a single device such as a plate, disposed between the first portion 120a and the second portion 120b, for exchanging heat between the heat source and the working fluid flowing through the plurality of flow paths 82a, 82b. In one non-limiting embodiment, the heat sink includes at least two plates operably coupled together in parallel, forming a flow channel between adjacent plates, and disposed between the first portion 120a and the second portion 120b. In some embodiments, the one or more plates of the heat sink 122 may include one or more grooves or surface features for improving heat exchanging properties.

Refrigerant flowing through the heat transfer apparatus 120 may re-enter subcooler 80 at one or more inlets (e.g., FIG. 2, 81, FIG. 3, 81a, 81b) or outlets (e.g., FIG. 2, 84, FIG. 3, 84a, 84b). In some embodiments, a flow path may have a single inlet 81 into or a single outlet 84 out of the heat transfer apparatus 120 as illustrated in FIG. 2. In alternate embodiments, the plurality of flow paths 82a, 82b may enter and exit the heat transfer apparatus 120 multiple times.

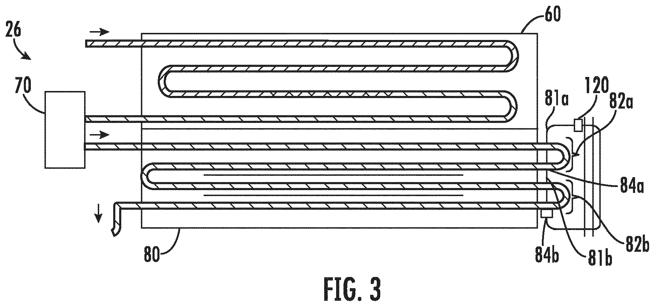

Turning to FIG. 3, subcooler 80 may have a plurality of flow paths, e.g., 82a, 82b. Flow path 82a, may enter the heat transfer apparatus 120 from subcooler 80 via inlet 81, and the re-enter the subcooler 80 via outlet 84a. Flow path 82b, may re-enter the heat transfer apparatus 120 via inlet 81b and re-enter subcooler 80 at via outlet 84b, where the refrigerant flow proceeds to the filter-drier 90 and economizer heat exchanger 110.

Returning to FIG. 2, filter-drier 90 which keeps the refrigerant clean and dry, and outlets refrigerant to a first refrigerant flow path 100 of an economizer heat exchanger 110, which increases refrigerant subcooling. Economizer heat exchanger 110 may be a plate-type heat exchanger, providing refrigerant heat exchange between a first refrigerant flow path 100 and a second refrigerant flow path 102.

From the first refrigerant flow path 100, the refrigerant flows from the economizer heat exchanger 110 to an expansion device 130. Expansion device 130 controls the ingress of refrigerant to evaporator 150. Expansion device 130 is controlled by controller 140 in response to signals from the evaporator outlet temperature sensor 132 and evaporator outlet pressure sensor 134. Evaporator fans (not shown) draw or push air over evaporator 150 to condition the air in compartment 40. Controller 140 may be microprocessor based and may control various operations of the TRU 26 including compressor 50, and expansion devices 112, 130, and may receive input from various sensors and user input devices, such as sensors 132, 134.

TRU 26 further includes a second refrigerant flow path 102 connected through the economizer heat exchanger 110. The second refrigerant flow path 102 is connected between the first refrigerant flow path 100 and an intermediate inlet port 160 of compressor 50. The intermediate inlet port 160 is located at an intermediate location along a compression path between compression suction port 53 and compressor discharge port 51. An economizer expansion device 112 is positioned in the second refrigerant flow path 102, upstream of the economizer heat exchanger 110. The economizer expansion device 112 may be an electronic economizer expansion device controlled by a controller 140. When the economizer 110 is active, controller 140 controls economizer expansion device 112 to allow refrigerant to pass through the second refrigerant flow path 102, through the economizer heat exchanger 110 and to intermediate inlet port 160. The economizer expansion device 112 serves to expand and cool the refrigerant, which proceeds into the economizer heat exchanger 110, thereby subcooling the liquid refrigerant in the first refrigerant flow path 102 proceeding to evaporator expansion device 130.

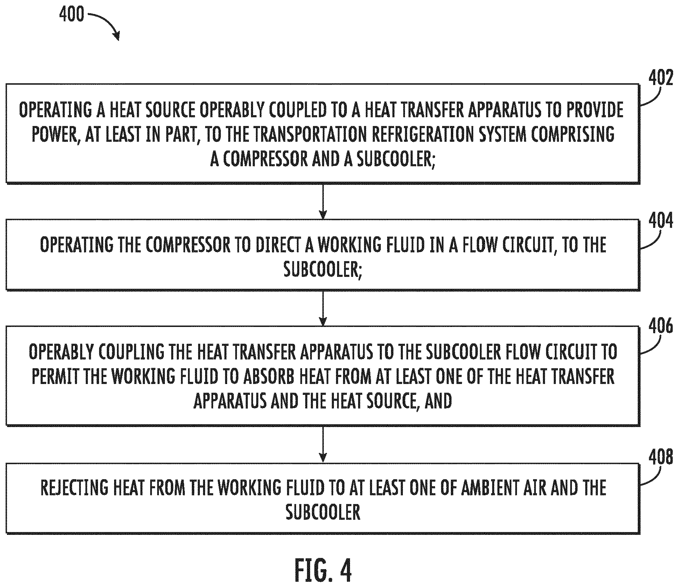

Referring to FIG. 4, a method for operating a transportation refrigeration system in accordance with the embodiments of the disclosure is shown. The method begins at step 402 with an operational transportation refrigeration system 100 and operating a heat source, such as a PEP operably coupled to a heat transfer apparatus 120 to provide power, at least in part, to the transportation refrigeration system 100. The transportation refrigeration system 100 includes a compressor 50 and a subcooler 80. The heat source may include at least one or more power electronics devices, including a power semiconductor device, a converter, an inverter, a battery and a fuel cell. The compressor 50 circulates a working fluid (e.g., refrigerant) in a closed circuit. The compressor 50 may be a single stage or two-stage compressor, a scroll type compressor or other compressors adapted to compress a working fluid, including HFCs or natural refrigerants.

In general, the heat source may be used to control the flow of electricity between one or more of a battery, a motor, a generator, a refrigeration transportation system, and a vehicle powertrain. During operation, the heat source generates heat as it supplies power to the truck and/or container, which heat must be dissipated to avoid overheating and damage to the heat source systems and components.

The transportation refrigeration system 100 may be configured to allow the heat generated by the heat source to be rejected to a working fluid (e.g., refrigerant). In step 404, the compressor 50 operates to direct the working fluid to the subcooler 80, which receives high pressure, subcooled refrigerant through a flow circuit 82, including 82a, 82b, from a heat rejection heat exchanger (e.g., condenser 60).

In step 406, the method includes operably coupling the heat transfer apparatus 120 to the subcooler refrigerant flow circuit (e.g., flow paths 82a, 82b) to permit the working fluid to absorb heat from at least one of the heat transfer apparatus 120 and the heat source. In some embodiments, the heat transfer apparatus 120 may have a channel through which the working fluid may flow to permit a heat exchange to occur.

In step 408, as the working fluid flows through the refrigerant flow circuit (e.g., flow paths 82a, 82b), heat from the heat source may be rejected to the working fluid as refrigerant passes through (or in some cases, over) the heat transfer apparatus 120. For example, by directing the flow of working fluid via 82a, 82b, a heat exchange may occur without the necessity of having a separate pump to push or pull the refrigerant through the heat transfer apparatus 120. The temperature of the working fluid as it flows through the subcooler 80 is generally in the range of -30 °C to 50 °C (-20 °F to 120 °F). In contrast, the heat source, and thus the heat of the heat sink 122 will be of a higher temperature such that the heat sink 122 will add heat to the working fluid which may be rejected to air as the working fluid flows through and then exits the subcooler 80.

While the present invention has been described with reference to an exemplary embodiment or embodiments, it will be understood by those skilled in the art that various changes may be made and equivalents may be substituted for elements thereof without departing from the scope of the present invention as defined in the appended claims. In addition, many modifications may be made to adapt a particular situation or material to the teachings of the present invention. Therefore, it is intended that the present invention not be limited to the particular embodiment disclosed as the best mode contemplated for carrying out this present invention, but that the present invention will include all embodiments falling within the scope of the claims.

## Claims

1. A transportation refrigeration system comprising:
a heat rejection heat exchanger (60);
a subcooler (80) comprising a plurality of flow paths (82a, 82b), the subcooler (80) operably coupled to the heat rejection heat exchanger (60); and
a heat transfer apparatus (120) consisting of a first portion (120a), a second portion (120b), and optionally a heat sink (122), wherein the first portion (120a) is operably coupled to at least one of the plurality of flow paths (82a, 82b) and the second portion (120b) is operably coupled to a heat source; **characterized in that**
the plurality of flow paths comprises a first flow path (82a) and at least a second flow path (82b); and
the first portion (120a) of the heat transfer apparatus (120) is disposed between the first flow path (82a) and the at least second flow path (82b).

2. The transportation refrigeration system of claim 1, further comprising: a compressor (50) comprising a suction port (53) and a discharge port (51), the compressor (50) configured to circulate a working fluid through a flow circuit wherein, the heat rejection heat exchanger (60) is operably coupled to a compressor discharge port; and a heat absorption heat exchanger is operably coupled to a compressor suction port.

3. The transportation refrigeration system of any preceding claim, wherein the heat transfer apparatus (120) comprises the heat sink (122), wherein the heat sink (122) comprises at least two plates operably coupled together in parallel forming a flow channel between adjacent plates, and is disposed between the first portion (120a) and the second portion (120b).

4. The transportation refrigeration system of any preceding claim, wherein the heat source comprises a power electronics device.

5. The transportation refrigeration system of claim 4, wherein the power electronics device controls the flow of electricity between one or more of a battery, a motor, a generator, a refrigeration transportation system, and a vehicle powertrain; and/or
wherein the power electronics device comprises at least one of a power semiconductor device, a converter, an inverter, a battery, and a fuel cell.

6. A method of operating a transportation refrigeration system according to claim 1, comprising:
operating a heat source operably coupled to the heat transfer apparatus (120) to provide power, at least in part, to the transportation refrigeration system comprising a compressor (50) and the subcooler (80);
operating the compressor (50) to direct a working fluid in a flow circuit, to the subcooler (80);
operably coupling the heat transfer apparatus (120) to the subcooler flow circuit to permit the working fluid to absorb heat from at least one of the heat transfer apparatus (120) and the heat source; and
rejecting heat from the working fluid to at least one of ambient air and the subcooler (80).

7. The method of operating a transportation refrigeration system of claim 6, wherein the working fluid is a high pressure, subcooled refrigerant.

8. The method of operating a transportation refrigeration system of claim 6 or 7, wherein the heat source comprises a power electronics device.

9. The method of operating a transportation refrigeration system of claim 8, wherein power electronics device controls the flow of electricity between one or more of a battery, a motor, a generator, a refrigeration transportation system, and a vehicle powertrain; and/or
wherein the power electronics device comprises at least one of a power semiconductor device, a converter, an inverter, a battery, and a fuel cell.

## Patentansprüche

1. Transportkühlsystem, umfassend:
einen Wärmeabfuhr-Wärmetauscher (60);
einen Unterkühler (80), der eine Vielzahl von Strömungswegen (82a, 82b) umfasst, wobei der Unterkühler (80) betriebswirksam mit dem Wärmeabfuhr-Wärmetauscher (60) gekoppelt ist; und
eine Wärmeübertragungsvorrichtung (120), bestehend aus einem ersten Abschnitt (120a), einem zweiten Abschnitt (120b) und optional einem Kühlkörper (122), wobei der erste Abschnitt (120a) betriebswirksam mit mindestens einem der Vielzahl von Strömungswegen (82a, 82b) gekoppelt ist und der zweite Abschnitt (120b) betriebswirksam mit einer Wärmequelle gekoppelt ist; **dadurch gekennzeichnet, dass**
die Vielzahl der Strömungswege einen ersten Strömungsweg (82a) und mindestens einen zweiten Strömungsweg (82b) umfasst; und
der erste Abschnitt (120a) der Wärmeübertragungsvorrichtung (120) zwischen dem ersten Strömungsweg (82a) und dem mindestens zweiten Strömungsweg (82b) angeordnet ist.

2. Transportkühlsystem nach Anspruch 1, ferner umfassend: einen Kompressor (50), umfassend eine Ansaugöffnung (53) und eine Auslassöffnung (51), wobei der Kompressor (50) konfiguriert ist, um ein Arbeitsfluid durch einen Strömungskreislauf zirkulieren zu lassen, wobei der Wärmeabfuhr-Wärmetauscher (60) betriebswirksam mit einer Kompressor-Auslassöffnung gekoppelt ist; und ein Wärmeabsorptions-Wärmetauscher betriebswirksam mit einer Kompressor-Ansaugöffnung gekoppelt ist.

3. Transportkühlsystem nach einem der vorhergehenden Ansprüche, wobei die Wärmeübertragungsvorrichtung (120) den Kühlkörper (122) umfasst, wobei der Kühlkörper (122) mindestens zwei Platten umfasst, die betriebswirksam parallel miteinander gekoppelt sind, die einen Strömungskanal zwischen benachbarten Platten bilden, und zwischen dem ersten Abschnitt (120a) und dem zweiten Abschnitt (120b) angeordnet ist.

4. Transportkühlsystem nach einem der vorhergehenden Ansprüche, wobei die Wärmequelle eine Leistungselektronikvorrichtung umfasst.

5. Transportkühlsystem nach Anspruch 4, wobei die Leistungselektronikvorrichtung den Stromfluss zwischen einer oder mehreren von einer Batterie, einem Motor, einem Generator, einem Kühltransportsystem und einem Fahrzeugantriebsstrang steuert; und/oder
wobei die Leistungselektronikvorrichtung mindestens eine von einer Leistungshalbleitervorrichtung, einem Wandler, einem Wechselrichter, einer Batterie und einer Brennstoffzelle umfasst.

6. Verfahren zum Betreiben eines Transportkühlsystems gemäß Anspruch 1, umfassend:
Betreiben einer Wärmequelle, die betriebswirksam mit der Wärmeübertragungsvorrichtung (120) gekoppelt ist, um dem Transportkühlsystem, das einen Kompressor (50) und den Unterkühler (80) umfasst, mindestens teilweise Energie bereitzustellen;
Betreiben des Kompressors (50), um ein Arbeitsfluid in einen Strömungskreislauf zu dem Unterkühler (80) zu leiten;
betriebswirksames Koppeln der Wärmeübertragungsvorrichtung (120) mit dem Strömungskreislauf des Unterkühlers, um es dem Arbeitsfluid zu ermöglichen, Wärme von mindestens einer der Wärmeübertragungsvorrichtung (120) und der Wärmequelle zu absorbieren; und
Abführen von Wärme aus dem Arbeitsfluid an mindestens eines von der Umgebungsluft und dem Unterkühler (80).

7. Verfahren zum Betreiben eines Transportkühlsystems nach Anspruch 6, wobei das Arbeitsfluid ein unterkühltes Hochdruckkältemittel ist.

8. Verfahren zum Betreiben eines Transportkühlsystems nach Anspruch 6 oder 7, wobei die Wärmequelle eine Leistungselektronikvorrichtung umfasst.

9. Verfahren zum Betreiben eines Transportkühlsystems nach Anspruch 8, wobei die Leistungselektronikvorrichtung den Stromfluss zwischen einer oder mehreren von einer Batterie, einem Motor, einem Generator, einem Kühltransportsystem und einem Fahrzeugantriebsstrang steuert; und/oder
wobei die Leistungselektronikvorrichtung mindestens eine von einer Leistungshalbleitervorrichtung, einem Wandler, einem Wechselrichter, einer Batterie und einer Brennstoffzelle umfasst.

## Revendications

1. Système de réfrigération de transport comprenant :
un échangeur de chaleur à rejet de chaleur (60) ;
un sous-refroidisseur (80) comprenant une pluralité de trajets d'écoulement (82a, 82b), le sous-refroidisseur (80) étant couplé de manière opérationnelle à l'échangeur de chaleur à rejet de chaleur (60) ; et
un appareil de transfert de chaleur (120) constitué d'une première partie (120a), d'une seconde partie (120b) et éventuellement d'un dissipateur thermique (122), dans lequel la première partie (120a) est couplée de manière opérationnelle à au moins un de la pluralité de trajets d'écoulement (82a, 82b) et la seconde partie (120b) est couplée de manière opérationnelle à une source de chaleur ; **caractérisé en ce que** la pluralité de trajets d'écoulement comprend un premier trajet d'écoulement (82a) et au moins un second trajet d'écoulement (82b) ; et
la première partie (120a) de l'appareil de transfert de chaleur (120) est disposée entre le premier trajet d'écoulement (82a) et l'au moins un second trajet d'écoulement (82b).

2. Système de réfrigération de transport selon la revendication 1, comprenant en outre : un compresseur (50) comprenant un orifice d'aspiration (53) et un orifice d'évacuation (51), le compresseur (50) étant configuré pour faire circuler un fluide de travail à travers un circuit d'écoulement dans lequel, l'échangeur de chaleur à rejet de chaleur (60) est couplé de manière opérationnelle à un orifice d'évacuation de compresseur ; et un échangeur de chaleur à absorption de chaleur est couplé de manière opérationnelle à un orifice d'aspiration de compresseur.

3. Système de réfrigération de transport selon une quelconque revendication précédente, dans lequel l'appareil de transfert de chaleur (120) comprend le dissipateur de chaleur (122), dans lequel le dissipateur de chaleur (122) comprend au moins deux plaques couplées de manière opérationnelle ensemble en parallèle formant un canal d'écoulement entre plaques adjacentes, et est disposé entre la première partie (120a) et la seconde partie (120b).

4. Système de réfrigération de transport selon une quelconque revendication précédente, dans lequel la source de chaleur comprend un dispositif électronique de puissance.

5. Système de réfrigération de transport selon la revendication 4, dans lequel le dispositif électronique de puissance commande le flux d'électricité entre une ou plusieurs parmi une batterie, un moteur, un générateur, un système de transport de réfrigération et un groupe motopropulseur de véhicule ; et/ou dans lequel le dispositif électronique de puissance comprend au moins l'un parmi un dispositif semi-conducteur de puissance, un convertisseur, un onduleur, une batterie et une pile à combustible.

6. Procédé de fonctionnement d'un système de réfrigération de transport selon la revendication 1, comprenant :
le fonctionnement d'une source de chaleur couplée de manière opérationnelle à l'appareil de transfert de chaleur (120) pour alimenter, au moins en partie, le système de réfrigération de transport comprenant un compresseur (50) et le sous-refroidisseur (80) ;
le fonctionnement du compresseur (50) pour diriger un fluide de travail dans un circuit d'écoulement, vers le sous-refroidisseur (80) ;
le couplage opérationnel de l'appareil de transfert de chaleur (120) au circuit d'écoulement de sous-refroidisseur pour permettre au fluide de travail d'absorber de la chaleur d'au moins l'un parmi l'appareil de transfert de chaleur (120) et la source de chaleur ; et
le rejet de chaleur du fluide de travail vers au moins l'un parmi l'air ambiant et le sous-refroidisseur (80).

7. Procédé de fonctionnement d'un système de réfrigération de transport selon la revendication 6, dans lequel le fluide de travail est un réfrigérant sous-refroidi à haute pression.

8. Procédé de fonctionnement d'un système de réfrigération de transport selon la revendication 6 ou 7, dans lequel la source de chaleur comprend un dispositif électronique de puissance.

9. Procédé de fonctionnement d'un système réfrigération de transport selon la revendication 8, dans lequel un dispositif électronique de puissance commande le flux d'électricité entre une ou plusieurs parmi une batterie, un moteur, un générateur, un système de transport de réfrigération et un groupe motopropulseur de véhicule ; et/ou
dans lequel le dispositif électronique de puissance comprend au moins un parmi un dispositif semi-conducteur de puissance, un convertisseur, un onduleur, une batterie et une pile à combustible.
